# EUROPEAN PATENT APPLICATION

(11) **EP 4 607 278 A1**
(43) Date of publication of application: **27.08.2025**
(21) Application number: 22962855.7
(22) Date of filing: 24.10.2022
(51) Int. Cl.: G03F 7/004, G03F 7/039, G03F 7/20, C08F 212/32, C08F 212/14

(54) **CHEMICALLY-AMPLIFIED POSITIVE PHOTORESIST COMPOSITION FOR PATTERN PROFILE IMPROVEMENT AND ETCH RESISTANCE ENHANCEMENT**

(30) Priority: 21.10.2022 KR 20220136057
(71) Applicant: Ycchem Co., Ltd., Gyeongsangbuk-do 40046 (KR)
(72) Inventor: CHOI, Young Cheol, Gumin-si Gyeongsangbuk-do 39179 (KR); LEE, Su Jin, Daegu 42634 (KR); LEE, Seung Hun, Dalseong-gun Daegu 42918 (KR); LEE, Seung Hyun, Daegu 42747 (KR)
(74) Representative: Ter Meer Steinmeister & Partner
(86) International application number: PCT/KR2022/016247
(87) International publication number: WO 2024/085293

(57) **Abstract**

The present invention relates to a photoresist composition that can be exposed with a light source having a wavelength of 248 nm, and to a chemically-amplified positive photoresist composition for pattern profile improvement and etch resistance enhancement, containing a phenolic polymer resin comprising a hydroxyl group, represented by chemical formula 4, in which one from among compounds represented by chemical formula 1 to chemical formula 3 is selected as an effectively-etch-resistant monomer and copolymerized. The present invention exhibits excellent etch resistance while a profile, which is more vertical than a conventional positive photoresist, is implemented.

## Description

### Technical Field

The present disclosure relates to a chemically-amplified positive photoresist composition for pattern profile improvement and etch resistance enhancement, which is characterized by including a hydroxyl group-containing phenolic polymer resin prepared by selecting a novel monomer that is effective in etch resistance and performing copolymerization.

### Background Art

In recent years, with developments in semiconductor manufacturing process technologies, semiconductor devices have been required to become smaller and more highly integrated. Accordingly, technologies capable of realizing ultra-fine patterns with line widths of tens of nanometers or less have been demanded. Advances in such technologies to form ultra-fine patterns have been fulfilled by light sources having smaller wavelengths, developments in process technologies by the light sources, developments of photoresists suitable for the light sources, and the like.

Photoresists are used in photolithography for forming all kinds of patterns. A photoresist refers to photosensitive resins capable of enabling images corresponding to exposure patterns to be obtainable by solubility changes in a developer under the action of light.

Such methods of forming photoresist patterns include a method using a negative tone developer (negative tone development (NTD)) and a method using a positive tone developer (positive tone development (PTD)).

While the method of forming patterns using a negative tone developer involves forming patterns by selectively dissolving and removing unexposed areas using a negative tone developer, the method of forming patterns using a positive tone developer involves forming patterns by selectively dissolving and removing exposed areas using a positive tone developer.

When compared to the method of forming patterns using a positive tone developer, the method of forming patterns using a negative tone developer facilitates the formation of patterns when realizing the same pattern by implementing reverse patterns in contact hole patterns or trench patterns, which are difficult to be formed due to insufficient exposure, and can form photoresist patterns more effectively by using organic solvents as developers for removing unexposed parts.

In the meantime, photolithography using photoresist compositions is typically composed of the following processes: applying a photoresist on a wafer for coating, evaporating a solvent by heating the coated photoresist for soft baking, producing an image with a light source passing through a photomask, forming a pattern by a difference in solubility of exposed and unexposed parts using a developer, and etching the wafer, thus completing a circuit.

Such a photoresist composition is made of a photosensitizer (photoacid generator) for generating acid through excimer laser irradiation, a base resin, and other additives. Polystyrene polymers with a structure in which a hydroxyl group is present in a phenolic structure are used basically as the base resin. In addition, any photosensitizer capable of generating acid (H⁺) at a specific wavelength is available. In most cases, photosensitizers based on sulfonium salt, sulfonyldiazo, benzosulfonyl, iodine, chlorine, carboxylic acid, and the like may be primarily used.

In addition, light sources primarily used for such processes as described above have a wavelength in the range of 365 nm to 193 nm, including an i-line, a krypton fluoride (KrF) excimer laser, and an argon fluoride (ArF) excimer laser. It is known that shorter wavelengths enable the formation of much finer patterns.

Among these, research and development of KrF laser (248 nm) photoresists, aiming for seeking optical micromachining, have continued despite the ArF laser (193 nm) system developed thereafter. This may be due to the following reasons: the development of next-generation ArF photoresists is not yet satisfactory, and the cost savings of using KrF photoresists for mass production of semiconductors are significant. In response to developments of such technologies, the performance of KrF photoresists also must be improved. For a representative example, a decrease in photoresist thickness continues to be required with high integration, so developments of photoresists with further enhanced dry etch resistance are in desperate need. Other required characteristics include high resolution, wide depth of focus (DOF) margin, defect-free thin film formation, adhesion to substrates, high contrast, fast sensitivity, chemical stability, and the like.

As described above, Korean Patent No. 10-0047038 "Chemically-Amplified Positive Photoresist Composition", Korean Patent No. 10-1363842 "Chemically-Amplified Positive Photoresist Composition and Method of Forming Resist Pattern Using Same", Korean Patent No. 10-1204915 "Photoresist Polymer, Photoresist Composition Including Same, and Method of Forming Photoresist Pattern Using Same", Korean Patent No. 10-0273108 "Copolymer for Preparing Photoresist and Chemically-Amplified Positive Photoresist Composition Containing Same", Korean Patent No. 10-1655947 "Negative Photoresist Composition for KrF Laser Having High Resolution and High Aspect Ratio", Korean Patent No. 10-1977886 "Chemically-Amplified Positive Photoresist Composition for Pattern Profile Improvement", Korean Patent No. 10-0676801 "Resist Material and Method of Forming Pattern", and the like are disclosed as patents in the art regarding KrF photoresist technology.

As described in the above patents, KrF photoresists primarily use polyhydroxystyrene and polystyrene polymers with good transmittance in a wavelength range of 248 nm to 365 nm as base polymers to improve resolution and sensitivity.

Such positive photoresists based on polyhydroxystyrene and polystyrene polymers have difficulties because the range thereof usable in processes based on light sources having wavelengths in the range of 248 nm to 365 nm is challenging due to slope pattern profiles, footing, or the like. Furthermore, disadvantages that the resolution realizable decreases as photoresist thickness increases, etch resistance is lacking, and depending on the type of underlying layer, problems such as lack of adhesion cause problems during processes are becoming critical issues.

### Disclosure

### Technical Problem

The present disclosure aims to provide a chemically-amplified positive photoresist composition in which a pattern has excellent sensitivity, resolution, and dimensional stability while a pattern profile is improved to be near-vertical, and etch resistance is enhanced so that, ultimately, the process margin is improved.

### Technical Solution

To address the above-described problems, the present disclosure provides a chemically-amplified positive photoresist composition for pattern profile improvement and etch resistance enhancement, which is characterized by including a hydroxyl group-containing phenolic polymer resin prepared by selecting a novel monomer that is effective in etch resistance for a chemically-amplified resist, as represented by Chemical Formulas 1 to 3 below, and performing copolymerization involving this monomer.

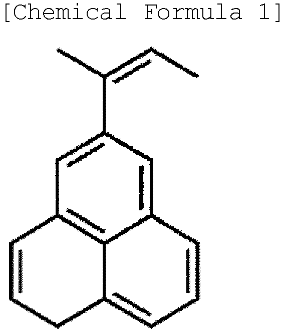

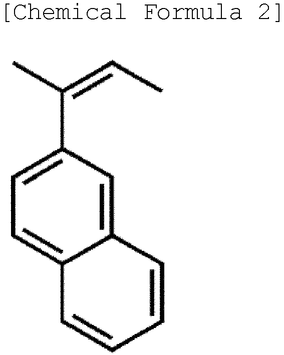

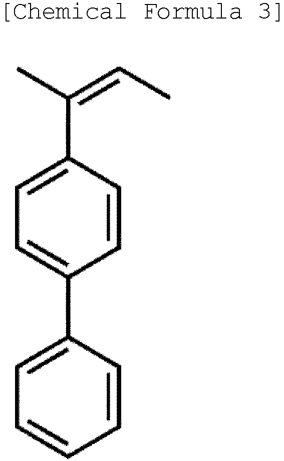

In the present disclosure, the novel monomer that is effective in etch resistance for the resist, as represented by Chemical Formulas 1 to 3, and similar structures are readily obtainable from multiple suppliers in Korea domestically and abroad.

In the present disclosure, the hydroxyl group-containing phenolic polymer resin, which is prepared by selecting one from among the compounds represented by Chemical Formulas 1 to 3 as the monomer that is effective in etch resistance and performing copolymerization involving this monomer, is represented by Chemical Formula 4 below and characterized by having a weight average molecular weight in the range of 1,000 to 400,000.

In the present disclosure, the photoresist composition is characterized by being a chemically-amplified positive photoresist composition for pattern profile improvement and etch resistance enhancement, which is characterized by including 5 to 60 wt% of the hydroxyl group-containing phenolic polymer resin represented by Chemical Formula 4 below, the phenolic polymer resin being prepared by selecting one from among the compounds represented by Chemical Formulas 1 to 3 as the monomer that is effective in etch resistance and performing copolymerization, 0.5 to 20 wt% of a photoacid generator, 0.01 to 5 wt% of a basic compound for acid diffusion inhibition, 0.01 to 2 wt% of a surfactant, and the remainder being an organic solvent, with respect to the total weight of the composition.

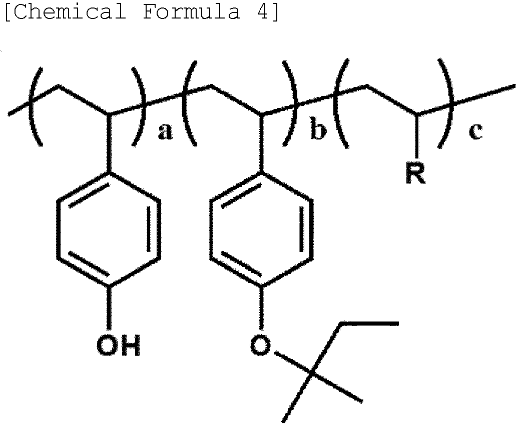

(In the structure of Chemical Formula 4, R is selected from the monomers represented by Chemical Formulas 1 to 3 above.)

The hydroxyl group-containing phenolic polymer resin represented by Chemical Formula 4 is characterized by having a copolymerization molar ratio of a:b:c in the range of 24.86 to 63.9:10.14 to 26.1:65 to 10.

In the present disclosure, examples of the photoacid generator include sulfonium salts, iodonium salts, sulfonyl diazomethane, N-sulfonyloxyimide-type acid generators, and the like, and any compound types to be described below can be used as the photoacid generator, either alone or in combination of two or more. The sulfonium salts are salts of sulfonium cations and sulfonates, including triphenylsulfonium, (4-tert-butoxyphenyl)diphenylsulfonium, bis(4-tert-butoxyphenyl)phenylsulfonium, tris(4-tert-butoxyphenyl)sulfonium, (3-tert-butoxyphenyl)diphenylsulfonium, bis(3-tert-butoxyphenyl)phenylsulfonium, tris(3-tert-butoxyphenyl)sulfonium, (3,4-ditert-butoxyphenyl)diphenylsulfonium, bis(3,4-ditert-butoxyphenyl)phenylsulfonium, tris(3,4-ditert-butoxyphenyl)sulfonium, diphenyl(4-thiophenoxyphenyl)sulfonium, (4-tert-butoxycarbonylmethyloxyphenyl)diphenylsulfonium, tris(4-tert-butoxycarbonylmethyloxyphenyl)sulfonium, (4-tert-butoxyphenyl)bis(4-dimethylaminophenyl)sulfonium, tris(4-dimethylaminophenyl)sulfonium, 2-naphthyldiphenylsulfonium, dimethyl 2-naphthylsulfonium, 4-hydroxyphenyl dimethylsulfonium, 4-methoxyphenyldimethylsulfonium, trimethylsulfonium, 2-oxocyclohexylcyclohexylmethylsulfonium, trinaphthylsulfonium, tribenzylsulfonium, and the like as sulfonium cations, and trifluoromethanesulfonate, nonafluorobutanesulfonate, heptadecafluorooctanesulfonate, 2,2,2-trifluoroethanesulfonate, pentafluorobenzenesulfonate, 4-trifluoromethylbenzenesulfonate, 4-fluorobenzenesulfonate, toluenesulfonate, benzenesulfonate, 4-(4-toluenesulfonyloxy)benzenesulfonate, naphthalenesulfonate, camphorsulfonate, octanesulfonate, dodecylbenzenesulfonate, butanesulfonate, methanesulfonate, and the like as sulfonates. In addition, the iodonium salts are salts of iodonium cations and sulfonates, including diphenyliodonium, bis(4-tert-butylphenyl)iodonium, 4-tert-butoxyphenylphenyliodonium, 4-methoxyphenylphenyliodonium, and the like as aryl iodonium cations, and trifluoromethanesulfonate, nonafluorobutanesulfonate, heptadecafluorooctanesulfonate, 2,2,2-trifluoroethanesulfonate, pentafluorobenzenesulfonate, 4-trifluoromethylbenzenesulfonate, 4-fluorobenzenesulfonate, toluenesulfonate, benzenesulfonate, 4-(4-toluenesulfonyloxy)benzenesulfonate, naphthalenesulfonate, camphorsulfonate, octanesulfonate, dodecylbenzenesulfonate, butanesulfonate, methanesulfonate, and the like as sulfonates. Examples of sulfonyl diazomethane may include sulfonylcarbonyldiazomethane and bissulfonyldiazomethane, such as bis(ethylsulfonyl)diazomethane, bis(1-methylpropylsulfonyl)diazomethane, bis(2-methylpropylsulfonyl)diazomethane, bis(1,1-dimethylethylsulfonyl)diazomethane, bis(cyclohexylsulfonyl)diazomethane, bis(perfluoroisopropylsulfonyl)diazomethane, bis(phenylsulfonyl)diazomethane, bis(4-methylphenylsulfonyl)diazomethane, bis(2,4-dimethylphenylsulfonyl)diazomethane, bis(2-naphthylsulfonyl)diazomethane, 4-methylphenylsulfonylbenzoyldiazomethane, tert-butylcarbonyl-4-methylphenylsulfonyldiazomethane, 2-naphthylsulfonylbenzoyldiazomethane, 4-methylphenylsulfonyl-2-naphthoyldiazomethane, methylsulfonylbenzoyldiazomethane, tert-butoxycarbonyl-4-methylphenylsulfonyldiazomethane, and the like. N-sulfonyloxyimide-type photoacid generators are characterized by including imide skeletons, such as succinimide, naphthalenedicarboxylic acid imide, phthalimide, cyclohexyl dicarboxylic acid imide, 5-norbornene-2,3-dicarboxylic acid imide, 7-oxabicyclo [2.2.1]-5-heptene-2,3-dicarboxylic acid imide, or the like, and one or more selected from the group consisting of trifluoromethanesulfonate, nonafluorobutanesulfonate, heptadecafluorooctanesulfonate, 2,2,2-trifluoroethanesulfonate, pentafluorobenzenesulfonate, 4-trifluoromethylbenzenesulfonate, 4-fluorobenzenesulfonate, toluenesulfonate, benzenesulfonate, naphthalenesulfonate, camphorsulfonate, octanesulfonate, dodecylbenzenesulfonate, butanesulfonate, methanesulfonate, and the like.

In the present disclosure, examples of the basic compound for acid diffusion inhibition may include primary, secondary, and tertiary aliphatic amines, hybrid amines, aromatic amines, heterocyclic amines, nitrogen-containing compounds having carboxyl groups, nitrogen-containing compounds having sulfonyl groups, nitrogen-containing compounds having hydroxyl groups, nitrogen-containing compounds having hydroxyphenyl groups, alcoholic nitrogen-containing compounds, amide derivatives, and imide derivatives, and any compound types to be described below can be used as the basic compound, either alone or in combination of two or more. Examples of the primary aliphatic amines may include ammonia, methylamine, ethylamine, n-propylamine, isopropylamine, n-butylamine, isobutylamine, sec-butylamine, tert-butylamine, pentylamine, tert-amylamine, cyclopentylamine, hexylamine, cyclohexylamine, heptylamine, octylamine, nonylamine, decylamine, dodecylamine, cetylamine, methylenediamine, ethylenediamine, tetraethylenepentamine, and the like. Examples of the secondary aliphatic amines may include dimethylamine, diethylamine, di-n-propylamine, diisopropylamine, di-n-butylamine, diisobutylamine, di-sec-butylamine, dipentylamine, dicyclopentylamine, dihexylamine, dicyclohexylamine, diheptylamine, dioctylamine, dinonylamine, didecylamine, didodecylamine, dicetylamine, N,N-dimethylmethylenediamine, N,N-dimethylethylenediamine, N,N-dimethyltetraethylenepentamine, and the like. Examples of the tertiary aliphatic amines may include trimethylamine, triethylamine, tri-n-propylamine, triisopropylamine, tri-n-butylamine, triisobutylamine, tri-sec-butylamine, tripentylamine, tricyclopentylamine, trihexylamine, tricyclohexylamine, triheptylamine, trioctylamine, trinonylamine, tridecylamine, tridodecylamine, tricetylamine, N,N,N',N'-tetramethylmethylenediamine, N,N,N',N'-tetramethylethylenediamine, and N,N,N',N'-tetramethyltetraethylenepentamine. Examples of the hybrid amines include dimethylethylamine, methylethylpropylamine, benzylamine, phenethylamine, benzyldimethylamine, and the like. Specific examples of the aromatic and heterocyclic amines include aniline derivatives (for example, aniline, N-methylaniline, N-ethylaniline, N-propylaniline, N,N-dimethylaniline, 2-methylaniline, 3-methylaniline, 4-methylaniline, ethylaniline, propylaniline, trimethylaniline, 2-nitroaniline, 3-nitroaniline, 4-nitroaniline, 2,4-dinitroaniline, 2,6-dinitroaniline, 3,5-dinitroaniline, N,N-dimethyltoluidine, and the like), diphenyl(p-tolyl)amine, methyldiphenylamine, triphenylamine, phenylenediamine, naphthylamine, diaminonaphthalene, pyrrole derivatives (for examples, pyrrole, 2H-pyrrole, 1-methylpyrrole, 2,4-dimethylpyrrole, 2,5-dimethylpyrrole, N-methylpyrrole, and the like), oxazole derivatives (for example, oxazole, isoxazole, and the like), thiazole derivatives (for example, thiazole, isothiazole, and the like), imidazole derivatives (for example, imidazole, 4-methylimidazole, 4-methyl-2-phenylimidazole, and the like), pyrazole derivatives, prazan derivatives, pyrroline derivatives (for example, pyrroline, 2-methyl-1-pyrroline, and the like), pyrrolidine derivatives (for example, pyrrolidine, N-methylpyrrolidine, pyrrolidinone, N-methylpyrrolidone, and the like), imidazoline derivatives, imidazolidine derivatives, pyridine derivatives (for example, pyridine, methylpyridine, ethylpyridine, propylpyridine, butylpyridine, 4-(1-butylpentyl)pyridine, dimethylpyridine, trimethylpyridine, triethylpyridine, phenylpyridine, 3-methyl-2-phenylpyridine, 4-tert-butylpyridine, diphenylpyridine, benzylpyridine, methoxypyridine, butoxypyridine, dimethoxypyridine, 1-methyl-2-pyridine, 4-pyrrolidinopyridine, 1-methyl-4-phenylpyridine, 2-(1-ethylpropyl)pyridine, aminopyridine, dimethylaminopyridine, and the like), pyridazine derivatives, pyrimidine derivatives, pyrazine derivatives, pyrazoline derivatives, pyrazolidine derivatives, piperidine derivatives, piperazine derivatives, morpholine derivatives, indole derivatives, isoindole derivatives, 1H-indazole derivatives, indoline derivatives, quinoline derivatives (for example, quinoline, 3-quinolinecarbonitrile, and the like), isoquinoline derivatives, cinnoline derivatives, quinazoline derivatives, quinoxaline derivatives, phthalazine derivatives, purine derivatives, pteridine derivatives, carbazole derivatives, phenanthridine derivatives, acridine derivatives, phenazine derivatives, 1,10-phenanthroline derivatives, adenine derivatives, adenosine derivatives, guanine derivatives, guanosine derivatives, uracil derivatives, and uridine derivatives. Examples of the nitrogen-containing compounds having carboxyl groups include amino benzoic acid, indole carboxylic acid, amino acid derivatives (for example, nicotinic acid, alanine, arginine, asparaginic acid, glutamic acid, glycine, histidine, isoleucine, glycylleucine, leucine, methionine, phenylalanine, threonine, lysine, 3-aminopyrazine-2-carboxylic acid, methoxyalanine, and the like), and the like. Examples of the nitrogen-containing compounds having sulfonyl groups include 3-pyridinesulfonic acid, p-toluenesulfonic acid pyridinium, and the like. Examples of the nitrogen-containing compounds having hydroxyl groups, the nitrogen-containing compounds having hydroxyphenyl groups, and the alcoholic nitrogen-containing compounds include 2-hydroxypyridine, aminocresol, 2,4-quinolindiol, 3-indolemethanol hydrate, monoethanolamine, diethanolamine, triethanolamine, N-ethyldiethanolamine, N,N-diethylethanolamine, triisopropanolamine, 2,2'-iminodiethanol, 2-aminoethanol, 3-amino-1-propanol, 4-amino-1-butanol, 4-(2-hydroxyethyl)morpholine, 2-(2-hydroxyethyl)pyridine, 1-(2-hydroxyethyl) piperazine, 1-[2-(2-hydroxyethoxy)ethyl]piperazine, piperidine ethanol, 1-(2-hydroxyethyl)pyrrolidine, 1-(2-hydroxyethyl)-2-pyrrolidinone, 3-piperidino-1,2-propanediol, 3-pyrrolidino-1,2-propanediol, 8-hydroxyurolidine, 3-quinuclidinol, 3-tropanol, 1-methyl-2-pyrrolidinethanol, 1-aziridinethanol, N-(2-hydroxyethyl)phthalimide, N-(2-hydroxyethyl)isonicotinamide, and the like. Examples of the amide derivatives include formamide, N-methylformamide, N,N-dimethylformamide, acetamide, N-methylacetamide, N,N-dimethylacetamide, propionamide, benzamide, and the like. The imide derivative is characterized by including one or more selected from the group consisting of phthalimide, succinimide, and maleimide.

In one preferred embodiment of the present disclosure, examples of the surfactant may include polyoxyethylenealkylethers, such as polyoxyethylenelaurylether, polyoxyethylenestearylether, polyoxyethylenecetylether, polyoxyethyleneoleinether, and the like, polyoxyethylenealkylallylethers, such as polyoxyethyleneoctylphenolether, polyoxyethylenenonylphenolether, and the like, polyoxyethylenepolyoxypropylene block copolymers, sorbitan fatty acid esters, such as sorbitanmonolaurate, sorbitanmonopalmitate, sorbitanmonostearate, and the like, non-ionic surfactants made of polyoxyethylenesorbitan fatty acid esters, such as polyoxyethylenesorbitanmonolaurate, polyoxyethylenesorbitanmonopalmitate, polyoxyethylenesorbitanmonostearate, polyoxyethylenesorbitantrioleate, polyoxyethylenesorbitantristearate, and the like, fluorine-based surfactants, such as EFTOP EF301, EF303, and EF352 (Tokem Products Co., Ltd.), MEGAFAC F171, F172, and F173 (Dainippon Ink and Chemicals, Inc.), FLUORAD FC430 and FC431 (Sumitomo 3M Ltd.), Asahi Guard AG710, Surflon S-381, S-382, SC101, SC102, SC103, SC104, SC105, and SC106, Surfinol E1004, KH-10, KH-20, KH-30, and KH-40 (Asahi Glass Co., Ltd.), and the like, organosiloxane polymers KP341, X-70-092, and X-70-093 (Shin-Etsu Chemical Co., Ltd.), and acrylic acid-based or methacrylic acid-based Polyflow No. 75 and No. 95 (Kyoeisha Chemical Co., Ltd.), among which is characterized by including one or more selected from the group consisting of FC430, Surflon S-381, and Surfinol E1004, KH-20, and KH-30.

### Advantageous Effects

The present disclosure can provide a chemically-amplified positive photoresist composition in which a pattern has excellent sensitivity, resolution, and dimensional stability while a pattern profile is improved to be near-vertical, and etch resistance is enhanced so that, ultimately, the process margin is significantly improved.

### Best Mode

Unless defined otherwise, all terms including technical and scientific terms used herein have the same meaning as those commonly understood by those skilled in the art to which the present disclosure pertains. In general, the nomenclature used herein is well-known and commonly used in the art.

Throughout this specification, it will be further understood that when one part is referred to as "comprising" or "including" one constituent element, this means that another constituent element may be further included but does not preclude the presence thereof unless the context clearly indicates otherwise.

In the present disclosure, the term "novel monomer effective in etch resistance" refers to a monomer structure capable of etch resistance improvement in an etching process that is performed in a subsequent process after a post-exposure bake (PEB) or hard bake (HB) process to be conducted after a process of being exposed to a light source having a wavelength in the range of 248 nm to 365 nm.

In the present disclosure, the term "photoresist" refers to a mixture of a polymer and a photosensitizer, whose solubility in a specific solvent changes when exposed to light having a specific wavelength due to changes in the chemical properties thereof caused by light, meaning that, due to the difference in the dissolution rates of the exposed and unexposed parts in the solvent, the part that has not been completely dissolved remains when a predetermined period of dissolution time elapses, thus forming a pattern.

In the present disclosure, the term "photolithography" refers to a process in which when placing a mask, on which a semiconductor design is imprinted, between a light source and a coated photoresist film applied on a silicon wafer and turning on the light source, a circuit imprinted on the mask is transferred to a photoresist, using the properties of the photoresist as described above.

In the present disclosure, the term "KrF" refers to a light source having a wavelength of 248 nm, and the term "i-line" refers to a light source having a wavelength of 365 nm.

One embodiment of the present disclosure provides a chemically-amplified positive photoresist composition for pattern profile improvement and etch resistance enhancement, which is characterized by including a hydroxyl group-containing phenolic polymer resin prepared by selecting a novel monomer that is effective in etch resistance for a chemically-amplified resist, as represented by Chemical Formulas 1 to 3 below, and performing copolymerization involving this monomer.

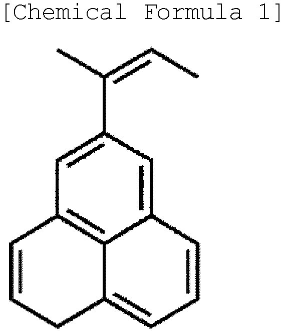

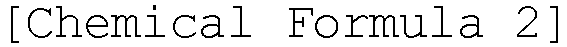

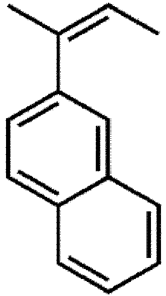

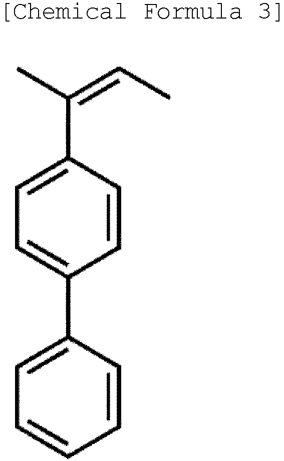

In one preferred embodiment of the present disclosure, the hydroxyl group-containing phenolic polymer resin, which is prepared by selecting one from among the compounds represented by Chemical Formulas 1 to 3 as the monomer that is effective in etch resistance and performing copolymerization involving this monomer, is represented by Chemical Formula 4 below.

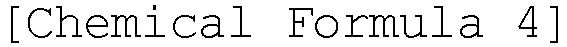

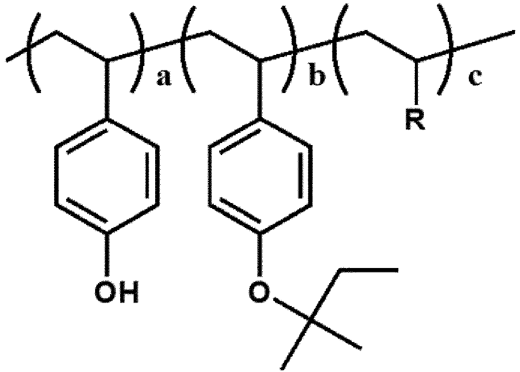

(In the structure of Chemical Formula 4, R is selected from the monomers represented by Chemical Formulas 1 to 3 above.)

In one preferred embodiment of the present disclosure, the hydroxyl group-containing phenolic polymer resin represented by Chemical Formula 4 is characterized by having a copolymerization molar ratio of a:b:c in the range of 24.86 to 63.9:10.14 to 26.1:65 to 10.

In one preferred embodiment of the present disclosure, the photoresist composition is characterized by being a chemically-amplified positive photoresist composition for pattern profile improvement and etch resistance enhancement, which is characterized by including 5 to 60 wt% of the hydroxyl group-containing phenolic polymer resin represented by Chemical Formula 4 below, the phenolic polymer resin being prepared by selecting one from among the compounds represented by Chemical Formulas 1 to 3 as the monomer that is effective in etch resistance and performing copolymerization, 0.5 to 20 wt% of a photoacid generator, 0.01 to 5 wt% of a basic compound for acid diffusion inhibition, 0.01 to 2 wt% of a surfactant, and the remainder being an organic solvent, with respect to the total weight of the composition.

In one preferred embodiment of the present disclosure, the hydroxyl group-containing phenolic polymer resin represented by Chemical Formula 4, which contains the novel monomer that is effective in etch resistance, as represented by Chemical Formulas 1 to 3, preferably has a weight average molecular weight in the range of 1,000 to 400,000. When the weight average molecular weight of the polymer resin is smaller than 1,000, not only there is no effect on the etch resistance of the photoresist, but also, at the same time, a vertical profile is impossible to be formed. In addition, when the weight average molecular weight of the polymer resin is greater than 400,000, despite being effective in etch resistance, residue-type defects may occur frequently after forming the pattern, which cause a decrease in the process margin and thus is undesirable.

In one preferred embodiment of the present disclosure, when it comes to the polymer resin, the polymer resin is preferably included in an amount range of 5 to 60 wt%, with respect to the total weight of the composition. When the amount of the polymer resin used is less than 5 wt%, there may be problems such as profile defects, scum, poor etch resistance, and the like. When the amount of the polymer resin used exceeds 60 wt%, there may be a problem that insufficient development causes patterning defects.

In one preferred embodiment of the present disclosure, examples of the photoacid generator include sulfonium salts, iodonium salts, sulfonyl diazomethane, N-sulfonyloxyimide-type acid generators, and the like, and any compound types to be described below can be used as the photoacid generator, either alone or in combination of two or more. The sulfonium salts are salts of sulfonium cations and sulfonates, including triphenylsulfonium, (4-tert-butoxyphenyl)diphenylsulfonium, bis(4-tert-butoxyphenyl)phenylsulfonium, tris(4-tert-butoxyphenyl)sulfonium, (3-tert-butoxyphenyl)diphenylsulfonium, bis(3-tert-butoxyphenyl)phenylsulfonium, tris(3-tert-butoxyphenyl)sulfonium, (3,4-ditert-butoxyphenyl)diphenylsulfonium, bis(3,4-ditert-butoxyphenyl)phenylsulfonium, tris(3,4-ditert-butoxyphenyl)sulfonium, diphenyl(4-thiophenoxyphenyl)sulfonium, (4-tert-butoxycarbonylmethyloxyphenyl)diphenylsulfonium, tris(4-tert-butoxycarbonylmethyloxyphenyl)sulfonium, (4-tert-butoxyphenyl)bis(4-dimethylaminophenyl)sulfonium, tris(4-dimethylaminophenyl)sulfonium, 2-naphthyldiphenylsulfonium, dimethyl 2-naphthylsulfonium, 4-hydroxyphenyl dimethylsulfonium, 4-methoxyphenyldimethylsulfonium, trimethylsulfonium, 2-oxocyclohexylcyclohexylmethylsulfonium, trinaphthylsulfonium, tribenzylsulfonium, and the like as sulfonium cations, and trifluoromethanesulfonate, nonafluorobutanesulfonate, heptadecafluorooctanesulfonate, 2,2,2-trifluoroethanesulfonate, pentafluorobenzenesulfonate, 4-trifluoromethylbenzenesulfonate, 4-fluorobenzenesulfonate, toluenesulfonate, benzenesulfonate, 4-(4-toluenesulfonyloxy)benzenesulfonate, naphthalenesulfonate, camphorsulfonate, octanesulfonate, dodecylbenzenesulfonate, butanesulfonate, methanesulfonate, and the like as sulfonates. In addition, the iodonium salts are salts of iodonium cations and sulfonates, including diphenyliodonium, bis(4-tert-butylphenyl)iodonium, 4-tert-butoxyphenylphenyliodonium, 4-methoxyphenylphenyliodonium, and the like as aryl iodonium cations, and trifluoromethanesulfonate, nonafluorobutanesulfonate, heptadecafluorooctanesulfonate, 2,2,2-trifluoroethanesulfonate, pentafluorobenzenesulfonate, 4-trifluoromethylbenzenesulfonate, 4-fluorobenzenesulfonate, toluenesulfonate, benzenesulfonate, 4-(4-toluenesulfonyloxy)benzenesulfonate, naphthalenesulfonate, camphorsulfonate, octanesulfonate, dodecylbenzenesulfonate, butanesulfonate, methanesulfonate, and the like as sulfonates. Examples of sulfonyl diazomethane may include sulfonylcarbonyldiazomethane and bissulfonyldiazomethane, such as bis(ethylsulfonyl)diazomethane, bis(1-methylpropylsulfonyl)diazomethane, bis(2-methylpropylsulfonyl)diazomethane, bis(1,1-dimethylethylsulfonyl)diazomethane, bis(cyclohexylsulfonyl)diazomethane, bis(perfluoroisopropylsulfonyl)diazomethane, bis(phenylsulfonyl)diazomethane, bis(4-methylphenylsulfonyl)diazomethane, bis(2,4-dimethylphenylsulfonyl)diazomethane, bis(2-naphthylsulfonyl)diazomethane, 4-methylphenylsulfonylbenzoyldiazomethane, tert-butylcarbonyl-4-methylphenylsulfonyldiazomethane, 2-naphthylsulfonylbenzoyldiazomethane, 4-methylphenylsulfonyl-2-naphthoyldiazomethane, methylsulfonylbenzoyldiazomethane, tert-butoxycarbonyl-4-methylphenylsulfonyldiazomethane, and the like. N-sulfonyloxyimide-type photoacid generators may include imide skeletons, such as succinimide, naphthalenedicarboxylic acid imide, phthalimide, cyclohexyl dicarboxylic acid imide, 5-norbornene-2,3-dicarboxylic acid imide, 7-oxabicyclo [2.2.1]-5-heptene-2,3-dicarboxylic acid imide, or the like, and one or more selected from the group consisting of trifluoromethanesulfonate, nonafluorobutanesulfonate, heptadecafluorooctanesulfonate, 2,2,2-trifluoroethanesulfonate, pentafluorobenzenesulfonate, 4-trifluoromethylbenzenesulfonate, 4-fluorobenzenesulfonate, toluenesulfonate, benzenesulfonate, naphthalenesulfonate, camphorsulfonate, octanesulfonate, dodecylbenzenesulfonate, butanesulfonate, methanesulfonate, and the like.

When it comes to the photoacid generator, the photoacid generator is preferably included in an amount range of 0.5 to 20 wt%, with respect to the total weight of the composition. When the amount of the photoacid generator used is less than 0.05 wt%, the slope surface angle of the pattern may become smaller than 90° due to the insufficiently generated acid. When the amount of the photoacid generator used exceeds 20 wt%, the photoacid generator may absorb the light from an exposure source, resulting in reduced transmittance and thus causing problems of pattern defects such as poor definition.

In one preferred embodiment of the present disclosure, examples of the basic compound for acid diffusion inhibition may include primary, secondary, and tertiary aliphatic amines, hybrid amines, aromatic amines, heterocyclic amines, nitrogen-containing compounds having carboxyl groups, nitrogen-containing compounds having sulfonyl groups, nitrogen-containing compounds having hydroxyl groups, nitrogen-containing compounds having hydroxyphenyl groups, alcoholic nitrogen-containing compounds, amide derivatives, and imide derivatives, and any compound types to be described below can be used as the basic compound, either alone or in combination of two or more. Examples of the primary aliphatic amines may include ammonia, methylamine, ethylamine, n-propylamine, isopropylamine, n-butylamine, isobutylamine, sec-butylamine, tert-butylamine, pentylamine, tert-amylamine, cyclopentylamine, hexylamine, cyclohexylamine, heptylamine, octylamine, nonylamine, decylamine, dodecylamine, cetylamine, methylenediamine, ethylenediamine, tetraethylenepentamine, and the like. Examples of the secondary aliphatic amines may include dimethylamine, diethylamine, di-n-propylamine, diisopropylamine, di-n-butylamine, diisobutylamine, di-sec-butylamine, dipentylamine, dicyclopentylamine, dihexylamine, dicyclohexylamine, diheptylamine, dioctylamine, dinonylamine, didecylamine, didodecylamine, dicetylamine, N,N-dimethylmethylenediamine, N,N-dimethylethylenediamine, N,N-dimethyltetraethylenepentamine, and the like. Examples of the tertiary aliphatic amines may include trimethylamine, triethylamine, tri-n-propylamine, triisopropylamine, tri-n-butylamine, triisobutylamine, tri-sec-butylamine, tripentylamine, tricyclopentylamine, trihexylamine, tricyclohexylamine, triheptylamine, trioctylamine, trinonylamine, tridecylamine, tridodecylamine, tricetylamine, N,N,N',N'-tetramethylmethylenediamine, N,N,N',N'-tetramethylethylenediamine, and N,N,N',N'-tetramethyltetraethylenepentamine. Examples of the hybrid amines include dimethylethylamine, methylethylpropylamine, benzylamine, phenethylamine, benzyldimethylamine, and the like. Specific examples of the aromatic and heterocyclic amines include aniline derivatives (for example, aniline, N-methylaniline, N-ethylaniline, N-propylaniline, N,N-dimethylaniline, 2-methylaniline, 3-methylaniline, 4-methylaniline, ethylaniline, propylaniline, trimethylaniline, 2-nitroaniline, 3-nitroaniline, 4-nitroaniline, 2,4-dinitroaniline, 2,6-dinitroaniline, 3,5-dinitroaniline, N,N-dimethyltoluidine, and the like), diphenyl(p-tolyl)amine, methyldiphenylamine, triphenylamine, phenylenediamine, naphthylamine, diaminonaphthalene, pyrrole derivatives (for examples, pyrrole, 2H-pyrrole, 1-methylpyrrole, 2,4-dimethylpyrrole, 2,5-dimethylpyrrole, N-methylpyrrole, and the like), oxazole derivatives (for example, oxazole, isoxazole, and the like), thiazole derivatives (for example, thiazole, isothiazole, and the like), imidazole derivatives (for example, imidazole, 4-methylimidazole, 4-methyl-2-phenylimidazole, and the like), pyrazole derivatives, prazan derivatives, pyrroline derivatives (for example, pyrroline, 2-methyl-1-pyrroline, and the like), pyrrolidine derivatives (for example, pyrrolidine, N-methylpyrrolidine, pyrrolidinone, N-methylpyrrolidone, and the like), imidazoline derivatives, imidazolidine derivatives, pyridine derivatives (for example, pyridine, methylpyridine, ethylpyridine, propylpyridine, butylpyridine, 4-(1-butylpentyl)pyridine, dimethylpyridine, trimethylpyridine, triethylpyridine, phenylpyridine, 3-methyl-2-phenylpyridine, 4-tert-butylpyridine, diphenylpyridine, benzylpyridine, methoxypyridine, butoxypyridine, dimethoxypyridine, 1-methyl-2-pyridine, 4-pyrrolidinopyridine, 1-methyl-4-phenylpyridine, 2-(1-ethylpropyl)pyridine, aminopyridine, dimethylaminopyridine, and the like), pyridazine derivatives, pyrimidine derivatives, pyrazine derivatives, pyrazoline derivatives, pyrazolidine derivatives, piperidine derivatives, piperazine derivatives, morpholine derivatives, indole derivatives, isoindole derivatives, 1H-indazole derivatives, indoline derivatives, quinoline derivatives (for example, quinoline, 3-quinolinecarbonitrile, and the like), isoquinoline derivatives, cinnoline derivatives, quinazoline derivatives, quinoxaline derivatives, phthalazine derivatives, purine derivatives, pteridine derivatives, carbazole derivatives, phenanthridine derivatives, acridine derivatives, phenazine derivatives, 1,10-phenanthroline derivatives, adenine derivatives, adenosine derivatives, guanine derivatives, guanosine derivatives, uracil derivatives, and uridine derivatives. Examples of the nitrogen-containing compounds having carboxyl groups include amino benzoic acid, indole carboxylic acid, amino acid derivatives (for example, nicotinic acid, alanine, arginine, asparaginic acid, glutamic acid, glycine, histidine, isoleucine, glycylleucine, leucine, methionine, phenylalanine, threonine, lysine, 3-aminopyrazine-2-carboxylic acid, methoxyalanine, and the like), and the like. Examples of the nitrogen-containing compounds having sulfonyl groups include 3-pyridinesulfonic acid, p-toluenesulfonic acid pyridinium, and the like. Examples of the nitrogen-containing compounds having hydroxyl groups, the nitrogen-containing compounds having hydroxyphenyl groups, and the alcoholic nitrogen-containing compounds include 2-hydroxypyridine, aminocresol, 2,4-quinolindiol, 3-indolemethanol hydrate, monoethanolamine, diethanolamine, triethanolamine, N-ethyldiethanolamine, N,N-diethylethanolamine, triisopropanolamine, 2,2'-iminodiethanol, 2-aminoethanol, 3-amino-1-propanol, 4-amino-1-butanol, 4-(2-hydroxyethyl)morpholine, 2-(2-hydroxyethyl)pyridine, 1-(2-hydroxyethyl) piperazine, 1-[2-(2-hydroxyethoxy)ethyl]piperazine, piperidine ethanol, 1-(2-hydroxyethyl)pyrrolidine, 1-(2-hydroxyethyl)-2-pyrrolidinone, 3-piperidino-1,2-propanediol, 3-pyrrolidino-1,2-propanediol, 8-hydroxyurolidine, 3-quinuclidinol, 3-tropanol, 1-methyl-2-pyrrolidinethanol, 1-aziridinethanol, N-(2-hydroxyethyl)phthalimide, N-(2-hydroxyethyl)isonicotinamide, and the like. Examples of the amide derivatives include formamide, N-methylformamide, N,N-dimethylformamide, acetamide, N-methylacetamide, N,N-dimethylacetamide, propionamide, benzamide, and the like. The imide derivative may include one or more selected from the group consisting of phthalimide, succinimide, and maleimide.

When it comes to the basic compound for acid diffusion inhibition, the basic compound for acid diffusion inhibition is preferably included in an amount range of 0.01 to 5 wt%, with respect to the total weight of the composition. When the amount of the basic compound for acid diffusion inhibition used is less than 0.01 wt%, the excessively generated acid may cause problems of pattern defects, leading to defects in the sidewall of patterns or those at the corners (line width roughness (LWR) and line edge roughness (LER)). When the amount of the basic compound for acid diffusion inhibition used exceeds 5 wt%, this may cause a problem where patterns are impossible to be formed.

In one preferred embodiment of the present disclosure, examples of the surfactant may include polyoxyethylenealkylethers, such as polyoxyethylenelaurylether, polyoxyethylenestearylether, polyoxyethylenecetylether, polyoxyethyleneoleinether, and the like, polyoxyethylenealkylallylethers, such as polyoxyethyleneoctylphenolether, polyoxyethylenenonylphenolether, and the like, polyoxyethylenepolyoxypropylene block copolymers, sorbitan fatty acid esters, such as sorbitanmonolaurate, sorbitanmonopalmitate, sorbitanmonostearate, and the like, non-ionic surfactants made of polyoxyethylenesorbitan fatty acid esters, such as polyoxyethylenesorbitanmonolaurate, polyoxyethylenesorbitanmonopalmitate, polyoxyethylenesorbitanmonostearate, polyoxyethylenesorbitantrioleate, polyoxyethylenesorbitantristearate, and the like, fluorine-based surfactants, such as EFTOP EF301, EF303, and EF352 (Tokem Products Co., Ltd.), MEGAFAC F171, F172, and F173 (Dainippon Ink and Chemicals, Inc.), FLUORAD FC430 and FC431 (Sumitomo 3M Ltd.), Asahi Guard AG710, Surflon S-381, S-382, SC101, SC102, SC103, SC104, SC105, and SC106, Surfinol E1004, KH-10, KH-20, KH-30, and KH-40 (Asahi Glass Co., Ltd.), and the like, organosiloxane polymers KP341, X-70-092, and X-70-093 (Shin-Etsu Chemical Co., Ltd.), and acrylic acid-based or methacrylic acid-based Polyflow No. 75 and No. 95 (Kyoeisha Chemical Co., Ltd.), among which may include one or more selected from the group consisting of FC430, Surflon S-381, and Surfinol E1004, KH-20, and KH-30.

In one preferred embodiment of the present disclosure, butyl acetate, amyl acetate, cyclohexyl acetate, 3-methoxybutyl acetate, methylethylketone, methylamylketone, cyclohexanone, cyclopentanone, 3-ethoxyethylpropionate, 3-ethoxymethylpropionate, 3-methoxymethylpropionate, methyl acetoacetate, ethyl acetoacetate, diacetonealcohol, methyl pyruvate, ethyl pyruvate, propyleneglycol monomethylether, propyleneglycol monoethylether, propyleneglycol monomethyletherpropionate, propyleneglycol monoethyletherpropionate, ethyleneglycol monomethylether, ethyleneglycol monoethylether, diethyleneglycol monomethyl ether, diethyleneglycol monoethylether, 3-methyl-3-methoxybutanol, N-methylpyrrolidone, dimethylsulfoxide, γ-butyrolactone, propyleneglycol methyletheracetate, propyleneglycol ethyletheracetate, propyleneglycol propyletheracetate, methyl lactate, ethyl lactate, propyl lactate, tetramethylenesulfone, and the like may be used as the solvent, either alone or in combination.

In the meantime, in one preferred embodiment of the present disclosure, the chemically-amplified positive photoresist composition for improving the profile and process margin compared to conventional KrF positive photoresists, the photoresist composition being prepared by introducing the novel monomer of the present disclosure, which is effective in etch resistance, and having a copolymerization molar ratio within an optimal range by introducing the appropriate amount thereof, may have a thickness that is available from 2,000 Å to 200,000 Å depending on the types and amount of solvents for use.

As described above, the chemically-amplified positive photoresist composition for improving the profile and process margin compared to conventional KrF positive photoresists, the photoresist composition being prepared by introducing the novel monomer of the present disclosure, which is effective in etch resistance, and having a copolymerization molar ratio within an optimal range by introducing the appropriate amount thereof, provided from the present disclosure enables a vertical profile to be obtainable by exposure energy with the addition of the novel monomer that is effective in etch resistance, as represented by Chemical Formulas 1 to 3, and is effective in etch resistance improvement, thus providing the process margin compared to conventional KrF photoresists.

### Mode for Invention

### [Example]

Hereinafter, the present disclosure will be described in more detail through examples. These examples are only for illustrating the present disclosure, and it will be apparent to those skilled in the art that the scope of the present disclosure is not to be construed as being limited by these examples. A positive photoresist composition for a KrF excimer laser was prepared by using a phenolic polymer resin having a weight average molecular weight of 16,100 (where in Chemical Formula 4, R is Chemical Formula 1 as a base resin, in which case a, b, and c for determining copolymerization molar ratios and the combination of other photoresist constituent elements were as shown in Table 1 below. The composition prepared above was applied on a silicon wafer for coating using a spin coater, followed by soft baking at a temperature of 100°C for 90 seconds to confirm a target thickness of 0.4 um. Once an exposure process in an excimer laser scanner at a wavelength of 248 nm was completed, a baking process (PEB) was conducted at a temperature of 110°C for 90 seconds, followed by a development process with 2.38% tetramethylammoniumhydroxide to form a pattern.

In addition, for the following evaluation of the etch characteristics of the wafers obtained in Examples 1 to 12, the etch resistance was evaluated using inductively coupled plasma reactive ion etching (ICP-RIE) equipment.

Elements other than the base resin are shown below.
PAG 1: 10-Camphorsulfonic acid(4-butoxyphenyl)diphenylsulfonium
PAG 2: 4-(4'-Methylphenylsulfonyloxy)phenylsulfonic acid(4-tert-butylphenyl)diphenylsulfonium
Basic compound for acid diffusion inhibition: Tris(2-methoxyethyl)amine
Surfactant A: FC-430
Surfactant B: Surflon S-38
Solvent A: Propyleneglycolmethyletheracetate
Solvent B: Ethyl lactate

**[Table 1]**

| **Classification** | | **Base resin (g)** | | **PAG (g)** | | **Basic compound for acid diffusion inhibition (g)** | **SurfactantSolvent (g)** | | **(g)** | |
|---|---|---|---|---|---|---|---|---|---|---|
| | | | **Weight Copolymerization ratio (a:b:c)** | **1** | **2** | | **A** | **B** | **A** | **B** |
| Example | 1 | 80 | 63.90 / 26.10 / 10 | 2 | 1 | 0.2 | 0.07 | 0.07 | 300 | 130 |
| | 2 | 80 | 60.35 / 24.65 / 15 | 2 | 1 | 0.2 | 0.07 | 0.07 | 300 | 130 |
| | 3 | 80 | 56.80 / 23.20 / 20 | 2 | 1 | 0.2 | 0.07 | 0.07 | 300 | 130 |
| | 4 | 80 | 53.25 / 21.75 / 25 | 2 | 1 | 0.2 | 0.07 | 0.07 | 300 | 130 |
| | 5 | 80 | 49.73 / 20.27 / 30 | 2 | 1 | 0.2 | 0.07 | 0.07 | 300 | 130 |
| | 6 | 80 | 46.15 / 18.85 / 35 | 2 | 1 | 0.2 | 0.07 | 0.07 | 300 | 130 |
| | 7 | 80 | 42.60 / 17.40 / 40 | 2 | 1 | 0.2 | 0.07 | 0.07 | 300 | 130 |
| | 8 | 80 | 39.05 / 15.95 / 45 | 2 | 1 | 0.2 | 0.07 | 0.07 | 300 | 130 |
| | 9 | 80 | 35.50 / 14.50 / 50 | 2 | 1 | 0.2 | 0.07 | 0.07 | 300 | 130 |
| | 10 | 80 | 31.96 / 13.04 / 55 | 2 | 1 | 0.2 | 0.07 | 0.07 | 300 | 130 |
| | 11 | 80 | 28.40 / 11.60 / 60 | 2 | 1 | 0.2 | 0.07 | 0.07 | 300 | 130 |
| | 12 | 80 | 24.86 / 10.14 / 65 | 2 | 1 | 0.2 | 0.07 | 0.07 | 300 | 130 |
| Comparative Example | 1 | 80 | 71 / 29 / 0 | 2 | 1 | 0.2 | 0.07 | 0.07 | 300 | 130 |

| | | | | | | | | | | |
|---|---|---|---|---|---|---|---|---|---|---|
| (the copolymerization ratio (a:b:c) is configured such that the ratio of Monomer a to Monomer b within the polymer resin remains constant at approximately 2.45, and as the example number increases from 1 to 12, the combined ratio of Monomer a and Monomer b decreases, while the ratio of Monomer c increases) | | | | | | | | | | |

### Property measurement

The properties of the chemically-amplified positive photoresist compositions for pattern profile improvement and etch resistance enhancement, which includes the phenolic polymer resin containing the novel monomer that is effective in pattern profile and etch resistance, prepared as in Examples 1 to 12 and Comparative Example 1 above, were measured.

Sensitivity, resolution, and profile types were measured using a critical-dimension scanning electron microscope (CD-SEM) capable of observing the line width (CD) of the patterns and confirmed by observing the line/space (L/S) minimum line width (resolution). In addition, regarding the sensitivity, the energy at which the minimum line width (resolution) was observable was measured to determine sensitivity.

The exposure amount that defines the top and bottom of the 0.15 µm-sized line and space at a 1:1 ratio was determined as the optimum exposure amount (sensitivity: Eop), and the minimum line width of the line and space resolved at this exposure amount was set as the resolution of the evaluated resist. For the photoresist pattern profile, the cross-section of the resist was observed using a scanning electron microscope.

The resist was exposed with the optimum exposure amount, left for 24 hours, and then subjected to PEB to evaluate the degree of line width variation as the post-exposure delay (PED) stability. The smaller the degree of variation, the better the PED stability.

The results measured as above are shown in Table 2 below.

**[Table 2]**

| Classification | | Sensitivity (mJ/cm²) | Resolution (µm) | Profile type | Dimensional stability after 24 h | Etch Resistance* (Å/sec) |
|---|---|---|---|---|---|---|
| Example | 1 | 32.0 | 0.15 | Nega-Slope | -8 | 0.77 |
| | 2 | 32.5 | 0.15 | Vertical | -8 | 0.76 |
| | 3 | 32.5 | 0.15 | Vertical | -8 | 0.76 |
| | 4 | 33.2 | 0.15 | Vertical | -8 | 0.76 |
| | 5 | 33.6 | 0.16 | Vertical | -7 | 0.70 |
| | 6 | 33.9 | 0.19 | Posi-Slope | -7 | 0.66 |
| | 7 | 34.8 | 0.20 | Posi-Slope | -7 | 0.65 |
| | 8 | 35.4 | 0.21 | Posi-Slope | -6 | 0.64 |
| | 9 | 36.3 | 0.23 | Posi-Slope | -6 | 0.64 |
| | 10 | 37.6 | 0.25 | Posi-Slope | -6 | 0.64 |
| | 11 | 38.5 | 0.28 | Posi-Slope | -6 | 0.63 |
| | 12 | 39.1 | 0.30 | Posi-Slope | -6 | 0.63 |
| Comparative Example | 1 | 32.5 | 0.15 | Posi-Slope | -13 | 1.0 |

| | | | | | | |
|---|---|---|---|---|---|---|
| (*: evaluated relatively by standardizing the etch resistance of Comparative Example 1 as 1) As confirmable in Table 1, the evaluation results with the increasing ratio of the novel monomer that is effective in etch resistance, contained in the base resin, confirms that Examples 1 to 12 exhibit improved etch resistance, meaning that these results tend to be better than those in the case of Comparative Example 1. In addition, the PED stability after 24 hours is also confirmed to be improved. Furthermore, when compared to the result in the case of Comparative Example 1, it is seen that the pattern profiles are also confirmed to be more vertical, and the optimum results are confirmable when the copolymerization molar ratio of the novel monomer that is effective in etch resistance is in the range of 15 to 25. When the novel monomer that is effective in etch resistance is contained at a copolymerization molar ratio of less than 15, Nega-Slope, meaning that the pattern profile type is abnormal, is confirmed. When the novel monomer that is effective in etch resistance is contained at a copolymerization molar ratio of 30 or more, despite being effective in etch resistance and PED stability after 24 hours, it is confirmed that there are no effects on sensitivity and resolution. | | | | | | |

In conclusion, when containing the novel monomer that is effective in etch resistance, as represented by Chemical Formulas 1 to 3, at a copolymerization molar ratio within a range of 15 to 25, which is the optimum content, it was confirmed that a photoresist composition for a KrF light source, the photoresist composition including the polymer resin containing the novel monomer that is effective in etch resistance and having an optimal effect in etch resistance improvement, could be provided.

Any simple modifications or changes to the present disclosure may be readily implemented by those skilled in the art and are to be regarded as falling within the scope of the present disclosure.

## Claims

1. A chemically-amplified positive photoresist composition for pattern profile improvement and etch resistance enhancement, the photoresist composition being exposable by a light source having a wavelength of 248 nm and comprising a hydroxyl group-containing phenolic polymer resin represented by Chemical Formula 4 below, wherein the polymer resin is prepared by selecting one from among compounds represented by Chemical Formulas 1 to 3 below as a monomer that is effective in etch resistance and performing copolymerization, 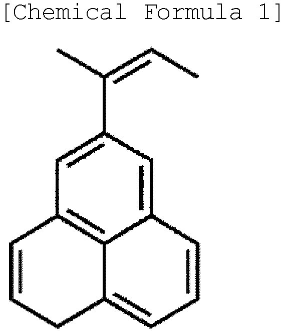 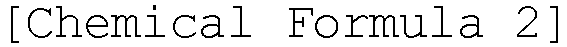 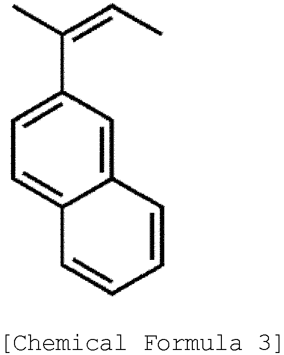 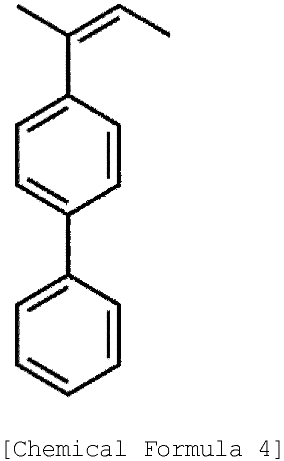 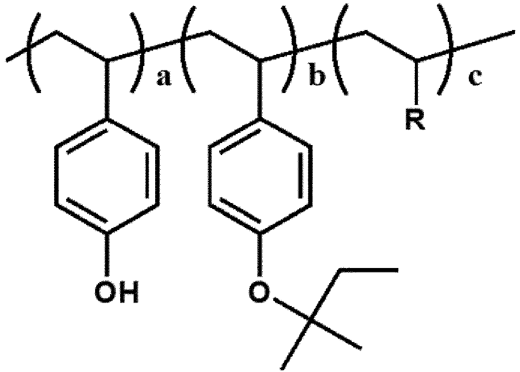 (where in the structure of Chemical Formula 4, R is selected from the monomers represented by Chemical Formulas 1 to 3).

2. The photoresist composition of claim 1, wherein the photoresist composition comprises 5 to 60 wt% of a polymer resin, 0.5 to 20 wt% of a photoacid generator, 0.01 to 5 wt% of a basic compound for acid diffusion inhibition, 0.01 to 2 wt% of a surfactant, and the remainder being an organic solvent, with respect to the total weight of the composition.

3. The photoresist composition of claim 2, wherein the polymer resin, serving as the hydroxyl group-containing phenolic polymer resin represented by Chemical Formula 4, has a copolymerization molar ratio of a:b:c in a range of 24.86 to 63.9:10.14 to 26.1:65 to 10.

4. The photoresist composition of claim 2, wherein the photoacid generator is one or more selected from the group consisting of triphenylsulfonium, (4-tert-butoxyphenyl)diphenylsulfonium, bis(4-tert-butoxyphenyl)phenylsulfonium, tris(4-tert-butoxyphenyl)sulfonium, (3-tert-butoxyphenyl)diphenylsulfonium, bis(3-tert-butoxyphenyl)phenylsulfonium, tris(3-tert-butoxyphenyl)sulfonium, (3,4-ditert-butoxyphenyl)diphenylsulfonium, bis(3,4-ditert-butoxyphenyl)phenylsulfonium, tris(3,4-ditert-butoxyphenyl)sulfonium, diphenyl(4-thiophenoxyphenyl)sulfonium, (4-tert-butoxycarbonylmethyloxyphenyl)diphenylsulfonium, tris(4-tert-butoxycarbonylmethyloxyphenyl)sulfonium, (4-tert-butoxyphenyl)bis(4-dimethylaminophenyl)sulfonium, tris(4-dimethylaminophenyl)sulfonium, 2-naphthyldiphenylsulfonium, dimethyl 2-naphthylsulfonium, 4-hydroxyphenyl dimethylsulfonium, 4-methoxyphenyldimethylsulfonium, trimethylsulfonium, 2-oxocyclohexylcyclohexylmethylsulfonium, trinaphthylsulfonium, tribenzylsulfonium, trifluoromethanesulfonate, nonafluorobutanesulfonate, heptadecafluorooctanesulfonate, 2,2,2-trifluoroethanesulfonate, pentafluorobenzenesulfonate, 4-trifluoromethylbenzenesulfonate, 4-fluorobenzenesulfonate, toluenesulfonate, benzenesulfonate, 4-(4-toluenesulfonyloxy)benzenesulfonate, naphthalenesulfonate, camphorsulfonate, octanesulfonate, dodecylbenzenesulfonate, butanesulfonate, methanesulfonate, diphenyliodonium, bis(4-tert-butylphenyl)iodonium, 4-tert-butoxyphenylphenyliodonium, 4-methoxyphenylphenyliodonium, trifluoromethanesulfonate, nonafluorobutanesulfonate, heptadecafluorooctanesulfonate, 2,2,2-trifluoroethanesulfonate, pentafluorobenzenesulfonate, 4-trifluoromethylbenzenesulfonate, 4-fluorobenzenesulfonate, toluenesulfonate, benzenesulfonate, 4-(4-toluenesulfonyloxy)benzenesulfonate, naphthalenesulfonate, camphorsulfonate, octanesulfonate, dodecylbenzenesulfonate, butanesulfonate, methanesulfonate, bis(ethylsulfonyl)diazomethane, bis(1-methylpropylsulfonyl)diazomethane, bis(2-methylpropylsulfonyl)diazomethane, bis(1,1-dimethylethylsulfonyl)diazomethane, bis(cyclohexylsulfonyl)diazomethane, bis(perfluoroisopropylsulfonyl)diazomethane, bis(phenylsulfonyl)diazomethane, bis(4-methylphenylsulfonyl)diazomethane, bis(2,4-dimethylphenylsulfonyl)diazomethane, bis(2-naphthylsulfonyl)diazomethane, 4-methylphenylsulfonylbenzoyldiazomethane, tert-butylcarbonyl-4-methylphenylsulfonyldiazomethane, 2-naphthylsulfonylbenzoyldiazomethane, 4-methylphenylsulfonyl-2-naphthoyldiazomethane, methylsulfonylbenzoyldiazomethane, tert-butoxycarbonyl-4-methylphenylsulfonyldiazomethane, succinimide, naphthalenedicarboxylic acid imide, phthalimide, cyclohexyl dicarboxylic acid imide, 5-norbornene-2,3-dicarboxylic acid imide, 7-oxabicyclo [2.2.1]-5-heptene-2,3-dicarboxylic acid imide, trifluoromethanesulfonate, nonafluorobutanesulfonate, heptadecafluorooctanesulfonate, 2,2,2-trifluoroethanesulfonate, pentafluorobenzenesulfonate, 4-trifluoromethylbenzenesulfonate, 4-fluorobenzenesulfonate, toluenesulfonate, benzenesulfonate, naphthalenesulfonate, camphorsulfonate, octanesulfonate, dodecylbenzenesulfonate, butanesulfonate, methanesulfonate, and the like.

5. The photoresist composition of claim 2, wherein the basic compound for acid diffusion inhibition is one or more selected from the group consisting of ammonia, methylamine, ethylamine, n-propylamine, isopropylamine, n-butylamine, isobutylamine, sec-butylamine, tert-butylamine, pentylamine, tert-amylamine, cyclopentylamine, hexylamine, cyclohexylamine, heptylamine, octylamine, nonylamine, decylamine, dodecylamine, cetylamine, methylenediamine, ethylenediamine, tetraethylenepentamine, dimethylamine, diethylamine, di-n-propylamine, diisopropylamine, di-n-butylamine, diisobutylamine, di-sec-butylamine, dipentylamine, dicyclopentylamine, dihexylamine, dicyclohexylamine, diheptylamine, dioctylamine, dinonylamine, didecylamine, didodecylamine, dicetylamine, N,N-dimethylmethylenediamine, N,N-dimethylethylenediamine, N,N-dimethyltetraethylenepentamine, trimethylamine, triethylamine, tri-n-propylamine, triisopropylamine, tri-n-butylamine, triisobutylamine, tri-sec-butylamine, tripentylamine, tricyclopentylamine, trihexylamine, tricyclohexylamine, triheptylamine, trioctylamine, trinonylamine, tridecylamine, tridodecylamine, tricetylamine, N,N,N',N'-tetramethylmethylenediamine, N,N,N',N'-tetramethylethylenediamine, N,N,N',N'-tetramethyltetraethylenepentamine, dimethylethylamine, methylethylpropylamine, benzylamine, phenethylamine, benzyldimethylamine, aniline, N-methylaniline, N-ethylaniline, N-propylaniline, N,N-dimethylaniline, 2-methylaniline, 3-methylaniline, 4-methylaniline, ethylaniline, propylaniline, trimethylaniline, 2-nitroaniline, 3-nitroaniline, 4-nitroaniline, 2,4-dinitroaniline, 2,6-dinitroaniline, 3,5-dinitroaniline, N,N-dimethyltolu, diphenyl(p-tolyl)amine, methyldiphenylamine, triphenylamine, phenylenediamine, naphthylamine, diaminonaphthalene, pyrrole, 2H-pyrrole, 1-methylpyrrole, 2,4-dimethylpyrrole, 2,5-dimethylpyrrole, N-methylpyrrole, oxazole, isoxazole, thiazole, isothiazole, imidazole, 4-methylimidazole, 4-methyl-2-phenylimidazole, pyrazole derivatives, prazan derivatives, pyrroline, 2-methyl-1-pyrroline, pyrrolidine, N-methylpyrrolidine, pyrrolidinone, N-methylpyrrolidone, imidazoline derivatives, imidazolidine derivatives, pyridine, methylpyridine, ethylpyridine, propylpyridine, butylpyridine, 4-(1-butylpentyl)pyridine, dimethylpyridine, trimethylpyridine, triethylpyridine, phenylpyridine, 3-methyl-2-phenylpyridine, 4-tert-butylpyridine, diphenylpyridine, benzylpyridine, methoxypyridine, butoxypyridine, dimethoxypyridine, 1-methyl-2-pyridine, 4-pyrrolidinopyridine, 1-methyl-4-phenylpyridine, 2-(1-ethylpropyl)pyridine, aminopyridine, dimethylaminopyridine, pyridazine derivatives, pyrimidine derivatives, pyrazine derivatives, pyrazoline derivatives, pyrazolidine derivatives, piperidine derivatives, piperazine derivatives, morpholine derivatives, indole derivatives, isoindole derivatives, 1H-indazole derivatives, indoline derivatives, quinoline, 3-quinolinecarbonitrile, isoquinoline derivatives, cinnoline derivatives, quinazoline derivatives, quinoxaline derivatives, phthalazine derivatives, purine derivatives, pteridine derivatives, carbazole derivatives, phenanthridine derivatives, acridine derivatives, phenazine derivatives, 1,10-phenanthroline derivatives, adenine derivatives, adenosine derivatives, guanine derivatives, guanosine derivatives, uracil derivatives, uridine derivatives, amino benzoic acid, indole carboxylic acid, nicotinic acid, alanine, arginine, asparaginic acid, glutamic acid, glycine, histidine, isoleucine, glycylleucine, leucine, methionine, phenylalanine, threonine, lysine, 3-aminopyrazine-2-carboxylic acid, methoxyalanine, 3-pyridinesulfonic acid, p-toluenesulfonic acid pyridinium, 2-hydroxypyridine, aminocresol, 2,4-quinolindiol, 3-indolemethanol hydrate, monoethanolamine, diethanolamine, triethanolamine, N-ethyldiethanolamine, N,N-diethylethanolamine, triisopropanolamine, 2,2'-iminodiethanol, 2-aminoethanol, 3-amino-1-propanol, 4-amino-1-butanol, 4-(2-hydroxyethyl)morpholine, 2-(2-hydroxyethyl)pyridine, 1-(2-hydroxyethyl) piperazine, 1-[2-(2-hydroxyethoxy)ethyl]piperazine, piperidine ethanol, 1-(2-hydroxyethyl)pyrrolidine, 1-(2-hydroxyethyl)-2-pyrrolidinone, 3-piperidino-1,2-propanediol, 3-pyrrolidino-1,2-propanediol, 8-hydroxyurolidine, 3-quinuclidinol, 3-tropanol, 1-methyl-2-pyrrolidinethanol, 1-aziridinethanol, N-(2-hydroxyethyl)phthalimide, N-(2-hydroxyethyl)isonicotinamide, formamide, N-methylformamide, N,N-dimethylformamide, acetamide, N-methylacetamide, N,N-dimethylacetamide, propionamide, benzamide, phthalimide, succinimide, maleimide, and the like.

6. The photoresist composition of claim 2, wherein the surfactant is one or more selected from the group consisting of polyoxyethylenelaurylether, polyoxyethylenestearylether, polyoxyethylenecetylether, polyoxyethyleneoleinether, polyoxyethyleneoctylphenolether, polyoxyethylenenonylphenolether, polyoxyethylenepolyoxypropylene block copolymers, sorbitanmonolaurate, sorbitanmonopalmitate, sorbitanmonostearate, polyoxyethylenesorbitanmonolaurate, polyoxyethylenesorbitanmonopalmitate, polyoxyethylenesorbitanmonostearate, polyoxyethylenesorbitantrioleate, polyoxyethylenesorbitantristearate, EFTOP EF301, EF303, and EF352, MEGAFAC F171, F172, and F173, FLUORAD FC430 and FC431, Asahi Guard AG710, Surflon S-381, S-382, SC101, SC102, SC103, SC104, SC105, and SC106, Surfinol E1004, KH-10, KH-20, KH-30, and KH-40, organosiloxane polymers KP341, X-70-092, and X-70-093, acrylic acid-based or methacrylic acid-based Polyflow No. 75 and No. 95, and the like.

7. The photoresist composition of claim 2, wherein the organic solvent is one or more selected from the group consisting of butyl acetate, amyl acetate, cyclohexyl acetate, 3-methoxybutyl acetate, methylethylketone, methylamylketone, cyclohexanone, cyclopentanone, 3-ethoxyethylpropionate, 3-ethoxymethylpropionate, 3-methoxymethylpropionate, methyl acetoacetate, ethyl acetoacetate, diacetonealcohol, methyl pyruvate, ethyl pyruvate, propyleneglycol monomethylether, propyleneglycol monoethylether, propyleneglycol monomethyletherpropionate, propyleneglycol monoethyletherpropionate, ethyleneglycol monomethylether, ethyleneglycol monoethylether, diethyleneglycol monomethyl ether, diethyleneglycol monoethylether, 3-methyl-3-methoxybutanol, N-methylpyrrolidone, dimethylsulfoxide, γ-butyrolactone, propyleneglycol methyletheracetate, propyleneglycol ethyletheracetate, propyleneglycol propyletheracetate, methyl lactate, ethyl lactate, propyl lactate, tetramethylenesulfone, and the like.
